Europäisches Patentamt

European Patent Office

Office européen des brevets

(11) Publication number: **0 291 282 B1**

# EUROPEAN PATENT SPECIFICATION

(45) Date of publication of patent specification: **27.12.95**   (51) Int. Cl.⁶: **G01N  24/08**

(21) Application number: **88304244.2**

(22) Date of filing: **11.05.88**

(54) Improvements in or relating to echo planar imaging systems

(30) Priority: **14.05.87 GB 8711379**

(43) Date of publication of application:
**17.11.88 Bulletin  88/46**

(45) Publication of the grant of the patent:
**27.12.95 Bulletin  95/52**

(84) Designated Contracting States:
**DE FR NL**

(56) References cited:
EP-A- 0 144 026
EP-A- 0 184 225
EP-A- 0 184 840
EP-A- 0 212 734

**IEEE TRANSACTIONS ON MEDICAL IMAGING,
MI-5 no. 1, page 2-7, March 1986, New York,
US; C.B. AHN et al.: "High-Speed Spiral-Scan
Echo Planar NMR Imaging-I"**

**MAGNETIC RESONANCE IN MEDICINE vol.2,
n 5, pages 479-489, October 1985, New York,
US; D.N. GUILFOYLE et al.: "Chemical-Shift
Imaging"**

(73) Proprietor: **BRITISH TECHNOLOGY GROUP
LIMITED
101 Newington Causeway
London SE1 6BU (GB)**

(72) Inventor: **Mansfield, Peter
66 Beeston Fields Drive
Beeston
Nottingham (GB)**
Inventor: **Ordidge, Roger John
70 Priory Road
West Bridgford
Nottingham NG2 5HW (GB)**
Inventor: **Coxon, Ronald John
10 Tranby Gardens
Wollaton
Nottingham (GB)**

(74) Representative: **Davis, Norman Norbridge et al
BRITISH TECHNOLOGY GROUP LTD
101 Newington Causeway
London SE1 6BU (GB)**

JOURNAL OF MAGNETIC RESONANCE vol.54, pages 338-343, 1983, New York, US; S. LJUN-GGREN: "A simple Graphical Representation of Fourier-Based Imaging Methods"

PATENT ABSTRACTS OF JAPAN vol.10, n 38 (P-428)(2095), 14th February1986; & JP-A-60 185 149

## Description

The present invention relates to Echo Planar Imaging (EPI) systems and more particularly to a method and apparatus for providing zonal magnification of a desired area of an image.

Echo Planar Imaging (EPI) is well known for its ultra high speed and ability to produce real time movies (Mansfield P. 1977 J. Physics C, 10.L55). The resolution obtainable with current EPI systems however is poor when compared with for example current commercial magnetic resonance imaging (MRI) equipment based on much slower imaging methods.

EP-A-0144026 discloses a technique for zonal magnification in a spin warp sequence NMR imaging system.

Patent Abstracts of Japan, Vol 10, No 38 (P-428) (2095), 14 February 1986; and JP-A-60185149 discloses a magnetic resonance imaging technique which selects a slice and then selects a line within the slice to produce a single line image. EP-A-0212734 discloses a two-shot process for stimulating a localized magnetic resonance spectrum by selectively inverting the magnetization of a sub-region prior to one of the excitations and subtracting the signals resulting from the two excitations.

The article Magnetic Resonance in Medicine, Vol 2, No. 5, pages 479-489, October 1985 discloses a process for obtaining chemical shift images by echo planar shift mapping techniques.

It is an object of the present invention to provide a true rapid zonal magnification of an image formed by EPI techniques (ie. a zoomed image) with genuine gains in resolution.

The present invention provides a method of zonal magnification of an image as claimed in claim 1.

In a first embodiment the defined area forms a central strip within a generally rectangular image field, the central strip being expanded to fill the complete image field.

In a second embodiment the defined area comprises a strip which is one quarter the width of the complete image field. Preferably four images are taken of the picture area each varying from the others by the selection of the defined quarter thereby rendering magnification of any quarter of the image field.

Preferably all images are permanently stored electronically for subsequent recovery of the enhanced image and for reference to the complete picture prior to enhancement.

The present invention provides apparatus for zonal magnification of an image as claimed in claim 5.

Embodiments of the present invention will now be described, by way of example with reference to the accompanying drawings in which:-

Figure 1 shows pulse and timing diagrams for a single or double Blipped Echo Planar Imaging (BEPI) sequence;

Figure 2 shows a map of k-space illustrating the sequence of Figure 1;

Figure 3 shows sketches of broadened stick spectra;

Figure 4 shows pulse and gradient timing diagrams for the present invention;

Figure 5 shows image field representations illustrating the present invention;

Figures 6 and 7 show various experimental results; and

Figure 8 illustrates the principles of a four fold zoom experiment.

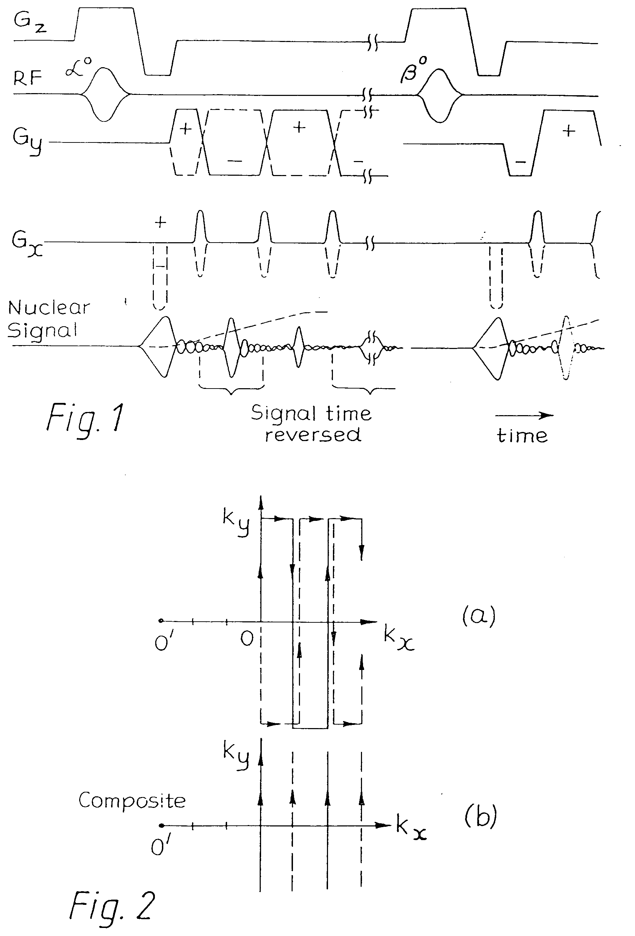

In normal unzoomed single slice imaging by BEPI, following slice selection by selective exitation (Garroway, Grannell and Mansfield, 1974 J. Phys. C 7, L457), the nuclear signal is allowed to evolve in an ideally square-wave modulated y-gradient $G_y$ and an x-gradient in the form of a series of delta function pulses. (In practice an approximately trapezoidal waveform is used for $G_y$ while $G_x$ is applied in the form of short but finite duration blips). The selective pulse and gradient timings are sketched in Figure 1. As sketched, the starting phase of $G_y$ may be +ve or -ve. The $G_x$ blips may be all +ve or all -ve. There are, therefore, four different possibilities for the nuclear signal, S(t), i.e. $S^{++}$, $S^{+-}$, $S^{-+}$ and $S^{--}$, each one of which is able to produce a single shot image.

The free induction decay signal S(t) in the rotating reference frame at time t following slice selection, is given generally by

$$S(t) = S(\underline{k}) = r.p. \int \rho(\underline{r})\exp[\underline{k}.\underline{r}]d\underline{r} \qquad (1)$$

where $\rho(\underline{r})$ is the spin density within the slice at position $\underline{r}$, and $\underline{k}$ is the reciprocal space wave vector (Mansfield and Grannell, 1973 J. Phys. C6, L422; 1975 Phys. Review 12, 3618; Ljunggren, 1983 J. Mag. Res. 54, 338) given by

$$\underline{k} = \int_{O}^{t} \gamma [\underline{i}G_x(t') + \underline{j}G_y(t')]dt' \qquad (2)$$

in which $\gamma$ is the magneto-gyric ratio and $G_x(t')$ and $G_y(t')$ are linear time-dependent magnetic field gradients.

Figure 2 shows various pathways scanning k-space which correspond to the different gradient combinations mentioned above. In performing the Fourier transform (FT) of the k-space map it is necessary that the arrows in the k-trajectories all point in the same direction. This may be achieved in two ways; the first by performing two experiments in rapid succession, the second of which has the starting phase of $G_y$ reversed. The $G_x$ blips have the same sense for both experiments. To equalize the signal amplitudes from both experiments, the first and second selective pulses muse have nutation angles of 45° and 90° respectively. The two signal echo trains may then be edited and spliced to produce two signals, in which spin evolution occurs effectively in either a wholly positive or wholly negative gradient. The $k_y$-trajectories for these spliced signals are either all negative to positive or vice versa. The two images produced upon Fourier transformation are inverted mirror images of each other. However, reversing and co-adding in image space results in a $\sqrt{2}$ improvement in signal-noise ratio. The above described procedure is a two shot imaging process and is similar to standard EPI.

The second procedure is a true one shot imaging process. Here, the signal echoes are recorded in a suitable electronic memory (not shown) after one selective pulse which may have a 90° nutation angle or some other arbitrary low angle, $\alpha°$. To get the k-trajectories all pointing in the same direction, time domain signals from alternate echoes are reversed. This edited decay signal is then Fourier transformed using a single one dimensional FT. This imaging process is hereinafter referred to as BEPI or BEST (Blipped Echoplanar Single-pulse Technique).

For square-wave gradient modulation, and when there is insignificant signal decay over the duration of an individual echo, it can be shown that for discrete signal sampling, the edited BEPI time signal is equivalent to the discrete function

$$S^{\pm +}(t) = \Sigma\Sigma \Delta x \Delta y \rho_{lm} \cos[1\Delta\omega_x + m\Delta\omega_y]t \qquad (3)$$

where l and m are integers and $\rho_{lm}$ is the density of the l,mth pixel with area $\Delta x \, \Delta y$.

The discrete Fourier transform of equation (3) over a sampling period T yields a stick spectrum with a discrete point spacing of

$$\Delta\omega_\rho = \Delta\omega_x = 2\pi/T = \gamma\Delta_x Gx \qquad (4)$$

and a stick spacing of

$$\Delta\omega_y = \gamma\Delta y G_y. \qquad (5)$$

For non-overlap of spectral components we must satisfy the condition

$$\Delta\omega_y = L\Delta\omega_x \qquad (6)$$

where L here and M below are the largest values of l ad m which span the object field.

The total number of points describing the image

$$P = LM \qquad (7)$$

From above, the total bandwidth required to handle a full image array is

$$\Delta\omega_\rho P = LM\Delta\omega_x = M\Delta\omega_y \qquad (8)$$

Referring to Figure 1 and to equations (4) and (5) we may also write

$$T = \tau P = M\tau_y \qquad (9)$$

for a complex FT where $\tau$ is the sampling period and the y-gradient echoes are modulo $2\tau_y$.

The zoom effect according to the present invention which we refer to as Zoomed EPI (ZEPI), is achieved as follows.

Let the object field be rectangular with a side length $\gamma$ a. From equation (8), together with the total frequency range representing the object field we may write the required gradient strength for normal BEPI as

$$G_y = M\Delta\omega_y/\gamma_a = LM\Delta\omega_x/\gamma_a = 2\pi LM/\gamma_a T. \tag{10}$$

For a rectangular image field L = M so that equation (10) predicts a squared dependence of $G_y$ on image array size M for constant T.

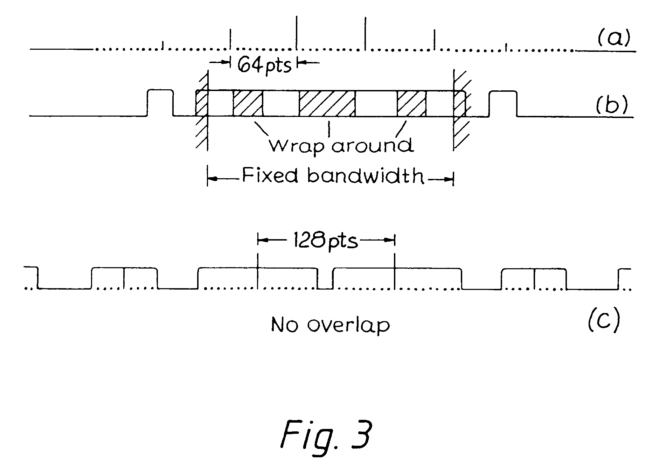

In ZEPI the object is to achieve with a small fixed array size the spatial resolution improvements normally associated with a large image array. In this case the stick spacing $\Delta\omega_y$ is kept constant in equation (10) thus making $G_y$ directly proportional to M. The same is true for equation (8) and means that for zoomed images the total bandwidth required to fully describe the image is proportional to M rather than $M^2$. The fact that the y-stick spacing, and hence the gradient modulation period, does not change means that an increase of the broadening x-gradient causes overlap or aliasing of the image. These points are best illustrated with examples of the stick and broadened spectra expected for particular arrays. Figure 3a shows the image spectrum for a 64 x 64 array. It is assumed that the object field as defined above is filled and that the data acquisition is bandwidth limited according to equation (8). Figure 3b represents the zoomed image spectrum when magnified by a factor of two. Some image information lies outside the receiver bandwidth and for fixed bandwidth is lost. However, by just doubling both the bandwidth and sampling rate so that 64 x 128 data points are captured, a 128 x 64 pixel image may be constructed. This image contains wrap-around artefact due to overlap of the broadened profiles. Figure 3c shows the image spectrum for a 128 x 128 image. The overlap apparent in Figure 3b is removed by virtue of the wider stick spacing concomitant with a change in the y-gradient switching period.

An experimental zoom sequences is now described which effectively removes the image wrap-around effect referred to above which occurs when the x-gradient is increased. The sequence uses 90° or lower angle selective pulses for initial slice selection plus a selective 180° pulse.

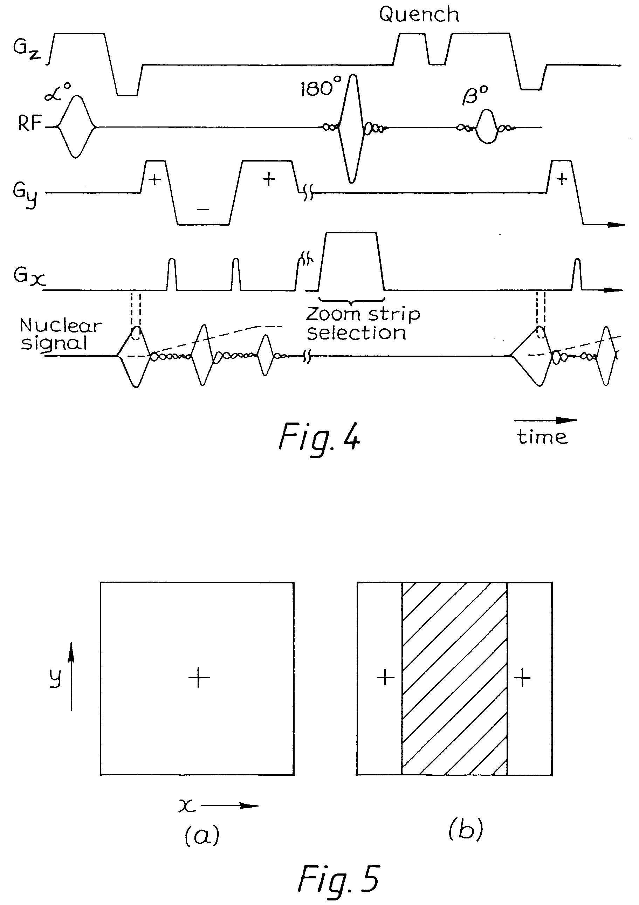

The sequence ZEPI-2 is a modified double BEPI experiment and is illustrated in Figure 4. The difference between this and Figure 1 is the selective 180° pulse sandwiched between the two BEPI experiments. This together with the x-gradient pulse constitute the zoom strip selection process. Ordinarily there would be no signal following a 180° pulse. However as a precaution against interference from residual signals a short burst gradient quench or scrambler pulse is preferably used which may be along y or z or a combination of all three axes. The zoom strip selection process is then rapidly followed by the second BEPI experiment. The slice selection pulses, $\alpha$ and $\beta$, may be 45° and 90° respectively for slow repetition experiments, or they may be low angle nutation pulses. In either case the angles must satisfy the expression (Mansfield, 1984, Mag. Res. Med. 1, 370).

$$\tan\alpha = \sin\beta \tag{11}$$

For low angles, $\alpha = \beta$.

If ZEPI-2 is to be applied in a fast repetition mode it is preferable to include a slice selective 180° RF pulse at the end of the sequence. This avoids alternation of the longitudinal spin magnetization in successive zoom experiments with an associated degradation in image quality from non-uniform spin-lattice relaxation.

A selective 180° RF pulse should immediately follow the two shot experiment of ZEPI-2.

The zooming procedure may be better understood by reference to Figure 5. Let Figure 5a represent the BEPI image from the first half of the zoom experiment. The + represents the signal phase of the image. Figure 5b is the BEPI image from the second half of the experiment. The selective 180° pulse reverses the signal phase in a well defined strip of the image as indicated. Subtraction of the two images leaves the central strip which may then be expanded along the x-axis to fill the whole of the image field. This is done by simply increasing the x-gradient. If viewed separately the images from each half of the zoom experiment exhibit wrap-around in the x-axis. But co-subtraction of the images completely removes this artefact. Expansion of the image along the y-axis is simply achieved by increasing the y-gradient with fixed receiver bandwidth. Image data at the top and bottom of the images are pushed outside the filter band width and therefore disappear from view. Of course, these lost data may be retained by increasing both the receiver bandwidth and the total number of sample points without further increasing either the x- or the y-gradient. In this case a full expanded image matrix would be available at no extra overhead in either time or gradient strength. However, such an approach involves handling larger data arrays and especially larger Fourier transforms. But as outlined hereinbefore, for a zoom factor of two the array size is doubled. This is contrasted with a standard BEPI or EPI approach where an increase in image resolution of a factor of two means a quadrupling in data array size and y-gradient strength.

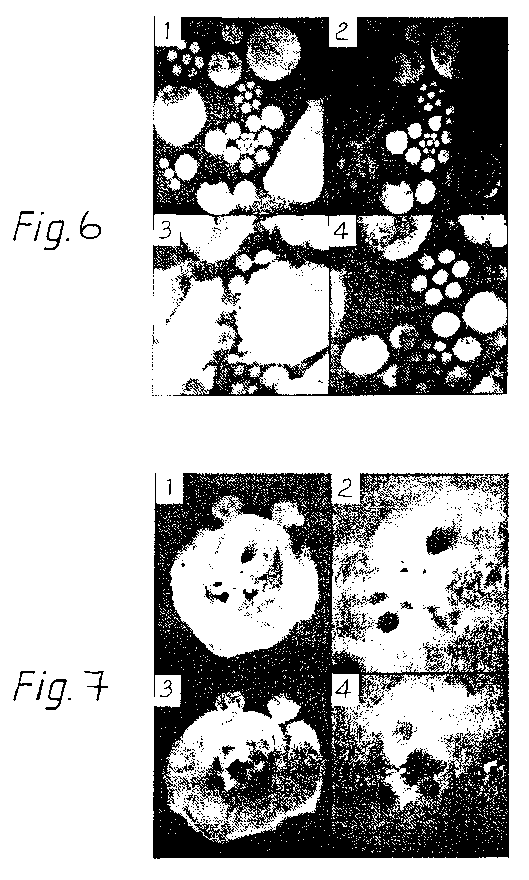

The ZEPI-2 sequence has been tried in practice. Figure 6 shows several images of a phantom each corresponding to various stages in a ZEPI-2 experiment. Figure 6.1 is the unzoomed BEPI image, the object field of which comprises a collection of bottles and tubes of various shapes and sizes which is referred to as the fruit phantom. Figure 6.2 is the selected strip for zooming from within the fruit phantom. Figure 6.3 is the magnified image without zoom strip selection and clearly demonstrates the wrap-around artefact in the x-axis. Figure 6.4 is the full zoom experiment with no wrap-around artefact. In this case image magnification is x2 along both axes. Note the much improved resolution of the cluster of small tubes in the upper right hand field of Figure 6.1. Each tube has a diameter of 5 mm with a spacing of around 1.5 mm. The basic spatial resolution in this image is 3 mm making the tubes just resolved in this cluster. This same cluster of tubes is clearly resolved in the fully zoomed image of Figure 6.4.

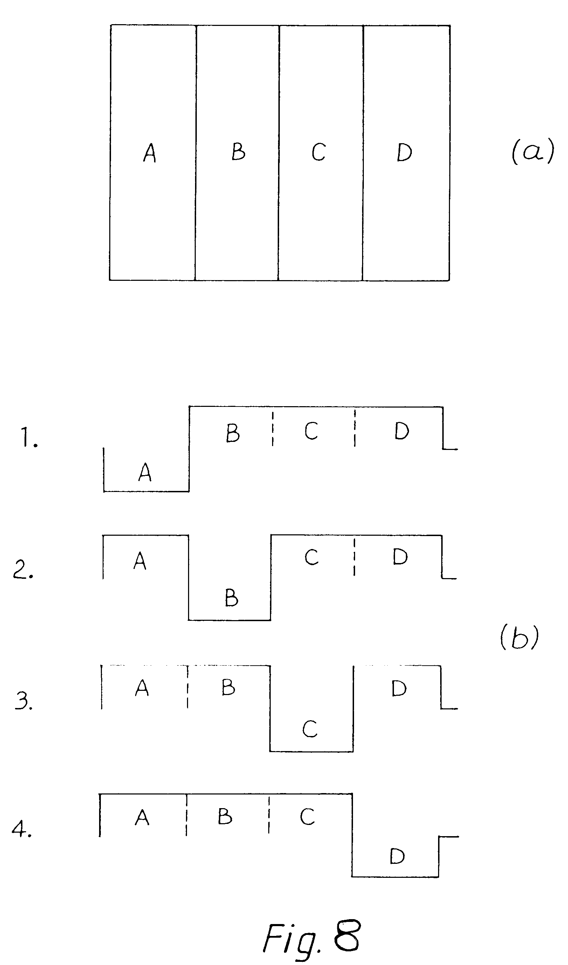

Figure 7 shows ZEPI-2 transections taken through the mediastinum of a live piglet. Figures 7.1 and 7.3 are unzoomed BEPI transections at different levels in the heart. Figures 7.2 and 7.4 are the corresponding zoomed images and demonstrate improved resolution of the major cardiac vessels and structures. The zoomed images are averages of 128 separate shots and took two minutes to accumulate at an operating Larmor frequency of 4 MHz.

The present invention is advantageous because standard EPI and standard BEPI imaging become more difficult to implement as array size, and hence resolution increases. This is because, for an m x m image array, the required gradient strength varies as $m^2$. In the zoomed imaging variants according to the present invention, however, the required gradient strength varies only as m.

The basic philosophy for zooming in accordance with the present invention is to work with a fixed image array size. Improvements in spatial resolution are then achieved by zonally magnifying smaller and smaller regions of the object field. In ZEPI-2 the full expanded data set is recoverable by minor modification of the zoom procedure. This means, for example, that a zoomed experiment with a 64 x 64 pixel array may be easily modified to give a 128 x 128 pixel array with no further demands on the gradient driver. Although zooming by more than a factor of two is possible, because of double or triple x-axis wrap-around, the full matrix data set is not recoverable.

The zoom version has been tried in practice and appears to work well. ZEPI-2 has the advantage, when zooming by a factor of two, that the full image field at the higher resolution is recoverable.

Further modifications of the zoom principle are possible which allow images comprising 256 x 256 pixels to be produced in four separate experiments and with a basic array size of 64 x 256. With suitably high x-gradients a fourfold wraparound would occur. But this can be unravelled, just as in the case described above for twofold wraparound. In accordance with a further embodiment of the present invention this is achieved by selectively inverting each of four contiguous strips in the image in each of the four experiments. Let the strips be labelled A, B, C and D (see Figure 8a). The x-gradient is increased until the selected strip width equals 64 points with fourfold wraparound. In this case the image will comprise signals from all four strips for each of the four experiments as follows:

1. -A + B + C + D
2. A - B + C + D
3. A + B - C + D
4. A + B + C - D

By co-adding the signals in the following patterns;

$$-1 + 2 + 3 + 4 = 4A$$
$$1 - 2 + 3 + 4 = 4B$$
$$1 + 2 - 3 + 4 = 4C$$
$$1 + 2 + 3 - 4 = 4D$$

each region of the image is completely recoverable so that the whole image may be constituted into a single 256 x 256 array. Creases in the image along the zoom selection edges may be minimized by using optimized selective inversion sequences.

If the whole imaging process takes m shots to perform, a signal-noise ratio improvement of $m^{1/2}$ is expected. In this example a factor of 2 improvement is obtained.

The y gradient waveforms are ideally rectangular. In this case the signal is linearly sampled so that equal increments $k_y$ of the reciprocal space wave vector occur between sample points. In practice the switched gradients have a finite slew rate making the waveform trapezoidal (see Figure 4). In such a case, signal sampling may be arranged to be non-linear in the ramped regions so that overall, equal increments $\Delta ky$ occur between sample points as in the ideal case. Any periodic y-gradient waveform may be used instead of that illustrated (e.g. cosinusoidal or triangular) provided the nuclear signal evolving under this gradient is non-linearly sampled with a suitable signal sampling pattern which generates equal increments of $\Delta k_y$. (See Mansfield and Ordidge - U.K. Patent No. 8128524).

The sampling times must be chosen such that

$$n \Delta k_y = \int_{t_{n-1}}^{t_n} \gamma \, g_y(t') \, dt.$$

for n = 1, 2, 3 .... where $t_n$ are the signal sampling times starting with $t_o = 0$.

A modification of ZEPI-2 is further described which allows modulus images rather than amplitude images to be produced.

The object is to introduce additional negative x-gradient pulses (marked in Figures 1 and 4 dotted) which effectively moves the starting point of the k-space scan, Figure 2, from 0 to 0'. This means that in the zoom experiment, the full k-plane is scanned. A power F.T. rather than an amplitude F.T. may therefore be performed on the signal echo trains (which now start with two signal amplitudes and grow to a peak before decaying away; see dotted echo envelope curves in Figures 1 and 4).

The effect of this change is that the images produced are independent of signal phase. This makes the experiment less dependent on local field inhomogenities and therefore experimentally more robust. We refer to this modulus version of zoom imaging as Z-MEPI-2.

It should be noted that since the images are phase independent, the additions and subtractions of data required for Z-MEPI-2 and for four fold and higher magnification must be performed with the time data.

## Claims

1. A method of zonal magnification of an image obtained by the echo-planar process comprising at least a two-shot process including the following steps:

   a) applying a first selective rf pulse ($\alpha^\circ$) in the presence of a slice defining gradient magnetic field ($G_z$),which reverses for a short time period following the RF pulse, to select a slice of an object to be imaged,

   b) applying repetitively a magnetic gradient field ($G_y$) with successive alternate polarities and having a gradient direction orthogonal to the slice defining magnetic field gradient ($G_z$) to generate a first train of echo signals,

   c) applying during step b) a phase encoding magnetic gradient field ($G_x$) having a gradient direction orthogonal to the said repetitive magnetic gradient field ($G_y$) and parallel to the selected slice so that the relative phases of signal contributions from the various sample elements differ from each other for successive echo signals,

   d) detecting the said first train of echo signals and deriving a first image signal therefrom,

   e) then applying in the presence of a strip selection gradient magnetic field ($G_x$) a selective 180° rf control pulse to invert the magnetism of a strip within the selected slice, the width of the strip depending on the magnitude of the gradient and spectral frequencies contained in the 180° rf pulse,

   f) applying a magnetic gradient field pulse ($G_z$) as a quench pulse,

   g) applying a second selective rf pulse ($\beta^\circ$) in the presence of the slice defining gradient magnetic field ($G_z$) to reselect the slice of the object to be imaged,

   h) repeating steps b) and c) to generate a second train of echo signals,

   i) detecting the said second train of echo signals and deriving a second image signal therefrom,

   j) taking the difference between the first and second image signals to derive an image signal limited to the strip selected in step (e), the amplitude of the phase-encoding gradient field ($G_x$) applied in step (c) being such that the images from each half of the two-shot process when viewed separately exhibit wrap-around in the phase encoding direction and that the resultant image of the selected strip is expanded along the phase encoding gradient direction to provide zonal magnification of the image of the selected strip.

2. The method as claimed in claim 1 in which the phase encoding magnetic gradient field ($G_x$) is blipped field.

3. The method as claimed in claim 2 in which the said phase encoding magnetic field gradient ($G_x$) is blipped at the time of change of polarity of the said echo generating repetitive gradient magnetic field ($G_y$).

4. The method as claimed in claim 1 in which the nutation angles of the first and second selective rf pulses ($\alpha°$ and $\beta°$) are related such that $\tan \alpha = \sin \beta$.

5. Apparatus for zonal magnification of an image obtained by the echo-planar process in at least a two-shot process, said apparatus comprising means suitably programmed for controlling means a-j to practise the method of claim 1, said means a-j comprising :

a) means for applying a first selective rf pulse ($\alpha°$) in the presence of a slice defining gradient magnetic field ($G_z$), which reverses for a short time period following the RF pulse, to select a slice of an object to be imaged,

b) means for applying repetitively a magnetic gradient field ($G_y$) with successive alternate polarities and having a gradient direction orthogonal to the slice defining magnetic field gradient ($G_z$) to generate a first train of echo signals,

c) means for applying simultaneously to the application of the said repetitive magnetic gradient field ($G_y$) a phase encoding magnetic gradient field ($G_x$) having a gradient direction orthogonal to the said repetitive magnetic gradient field ($G_y$) and parallel to the selected slice so that the relative phases of signal contributions from the various sample elements differ from each other for successive echo signals,

d) means for detecting the said first train of echo signals and deriving a first image signal therefrom,

e) means for then applying in the presence of a strip selection gradient magnetic field ($G_x$) a selective 180° rf control pulse to invert the magnetism of a strip within the selected slice, the width of the strip depending on the magnitude of the gradient and spectral frequencies contained in the 180° rf pulse,

f) means for applying a magnetic gradient field pulse ($G_z$) as a quench pulse,

g) means for applying a second selective rf pulse ($\beta°$) in the presence of the slice defining gradient magnetic field ($G_z$) to reselect the slice of the object to be imaged,

h) means for re-applying the magnetic gradient fields ($G_y$ and $G_x$) as specified in parts b) and c) to generate a second train of echo signals,

i) means for detecting the said second train of echo signals and deriving a second image signal therefrom, and

j) means for taking the difference between the first and second image signals to derive an image signal limited to the strip selected by means e) and having established an image from the difference, and means for increasing the amplitude of the phase encoding gradient to a level such that the images from each half of the two-shot process when viewed separately exhibit wrap-around in the phase encoding direction and that the resultant image of the selected strip is expanded along the phase encoding gradient direction to provide zonal magnification of the image of the selected strip.

**Patentansprüche**

1. Verfahren zur Flächenvergrößerung eines Bildes, das durch das "Echo-Planar"-Verfahren erhalten wurde, umfassend zumindest ein Zwei-Bild-Aufnahmeverfahren, das die folgenden Schritte umfaßt:

a) Anlegen eines ersten ausgewählten rf-Pulses ($\alpha°$) in Anwesenheit eines einen Ausschnitt definierenden Gradientmagnetfeldes ($G_z$), das sich für einen kurzen Zeitraum anschließend an den RF-Puls umkehrt, um einen Ausschnitt eines aufzunehmenden Gegenstands auszuwählen,

b) wiederholtes Anlegen eines magnetischen Gradientfeldes ($G_y$) mit sukzessiv wechselnden Polaritäten, das eine Gradientrichtung aufweist, die orthogonal zu dem den Ausschnitt definierenden Magnetfeldgradienten ($G_z$) ist, um eine erste Folge von Echosignalen zu erzeugen,

c) Anlegen eines phasenkodierten magnetischen Gradientfeldes ($G_x$) während Schritt b), das eine Gradientrichtung aufweist, die orthogonal zu dem wiederholten magnetischen Gradientfeld ($G_y$) und parallel zu dem ausgewählten Ausschnitt ist, so daß sich die relativen Phasen der Signalbeiträge von den verschiedenen Musterteilen für die sukzessiven Echosignale voneinander unterscheiden,

d) Ermitteln der ersten Folge von Echosignalen und Ableiten eines ersten Bildsignals von dieser Folge,

e) anschließendes Anlegen eines ausgewählten 180°-rf-Steuerpulses in Anwesenheit eines Streifen-auswahl-Gradientmagnetfeldes ($G_x$), um den Magnetismus eines Streifens innerhalb des ausgewählten Ausschnitts umzukehren, wobei die Breite des Streifens von der Größe des Gradienten und den in dem 180°-rf-Puls enthaltenen Spektralfrequenzen abhängt,

f) Anlegen eines magnetischen Gradientfeldpulses ($G_z$) als Ablöschpuls,

g) Anlegen eines zweiten ausgewählten rf-Pulses ($\beta°$) in Anwesenheit eines den Ausschnitt definierenden Gradientmagnetfeldes ($G_z$), um den Ausschnitt des aufzunehmenden Gegenstandes wieder auszuwählen,

h) Wiederholen der Schritte b) und c), um eine zweite Folge von Echosignalen zu erzeugen,

i) Ermitteln der zweiten Folge von Echosignalen und Ableiten eines zweiten Bildsignals aus dieser Folge,

j) Verwenden des Unterschieds zwischen dem ersten und dem zweiten Bildsignal, um ein Bildsignal abzuleiten, das auf den in Schritt e) ausgewählten Streifen begrenzt ist, wobei die Amplitude des phasenkodierenden Gradientfeldes ($G_x$), das in Schritt c) angelegt wurde, so bemessen ist, daß sich die Bilder von jeder Hälfte des Zwei-Bild-Aufnahmeverfahrens, wenn man sie separat betrachtet, in Phasenkodierungsrichtung überlagern, und daß das von dem ausgewählten Streifen erhaltene Bild in Richtung des phasenkodierenden Gradienten expandiert ist, um eine Flächenvergrößerung des Bildes von dem ausgewählten Streifen bereitzustellen.

**2.** Verfahren nach Anspruch 1,
bei dem das phasenkodierende magnetische Gradientfeld ($G_x$) ein gezacktes Feld ist.

**3.** Verfahren nach Anspruch 2,
bei dem der phasenkodierende Magnetfeldgradient ($G_x$) zum Zeitpunkt des Polaritätswechsels des echoerzeugenden wiederholten Gradientmagnetfeldes ($G_y$) gezackt ist.

**4.** Verfahren nach Anspruch 1,
bei dem die Nutationswinkel des ersten und zweiten ausgewählten rf-Pulses ($\alpha°$ und $\beta°$) so zueinander in Beziehung stehen, daß $\tan \alpha = \sin \beta$.

**5.** Vorrichtung zur Flächenvergrößerung eines Bildes, das durch das "Echo-Planar"-Verfahren in zumindest einem Zwei-Bild-Aufnahmeverfahren erhalten wurde, wobei die Vorrichtung eine Vorrichtung umfaßt, die dafür programmiert ist, die Vorrichtungen a-j zu steuern, um das Verfahren nach Anspruch 1 auszuführen, wobei die Vorrichtungen a-j folgendes umfassen:

a) eine Vorrichtung zum Anlegen eines ersten ausgewählten rf-Pulses ($\alpha°$) in Anwesenheit eines einen Ausschnitt definierenden Gradientmagnetfeldes ($G_z$), das sich für einen kurzen Zeitraum anschließend an den RF-Puls umkehrt, um einen Ausschnitt eines aufzunehmenden Gegenstandes auszuwählen,

b) eine Vorrichtung zum wiederholten Anlegen eines magnetischen Gradientfeldes ($G_y$) mit sukzessiv wechselnden Polaritäten, das eine Gradientrichtung aufweist, die orthogonal zu dem den Ausschnitt definierenden Magnetfeldgradienten ($G_z$) ist, um eine erste Folge von Echosignalen zu erzeugen,

c) eine Vorrichtung zum Anlegen, gleichzeitig mit dem Anlegen des wiederholten magnetischen Gradientfeldes ($G_y$), eines phasenkodierenden magnetischen Gradientfeldes ($G_x$) mit einer Gradient-richtung, die orthogonal zu dem wiederholten magnetischen Gradientfeld ($G_y$) und parallel zu dem ausgewählten Ausschnitt ist, so daß sich die relativen Phasen der Signalbeiträge von den verschiedenen Musterteilen für die sukzessiven Echosignale voneinander unterscheiden,

d) eine Vorrichtung zum Ermitteln der ersten Folge von Echosignalen und zum Ableiten eines ersten Bildsignals von dieser Folge,

e) eine Vorrichtung zum anschließenden Anlegen eines ausgewählten 180°-rf-Steuerpulses in Anwesenheit eines Streifenauswahl-Gradientmagnetfelds ($G_x$), um den Magnetismus eines Streifens innerhalb des ausgewählten Abschnitts umzukehren, wobei die Breite des Streifens von der Größe des Gradienten und den in dem 180°-rf-Puls enthaltenen Spektralfrequenzen abhängt,

f) eine Vorrichtung zum Anlegen eines magnetischen Gradientfeldpulses ($G_z$) als Ablöschpuls,

g) eine Vorrichtung zum Anlegen eines zweiten ausgewählten rf-Pulses ($\beta °$) in Anwesenheit des den Ausschnitt definierenden Gradientmagnetfeldes ($G_z$), um den Ausschnitt des aufzunehmenden Gegenstandes wieder auszuwählen,

h) eine Vorrichtung zum Wiederanlegen der magnetischen Gradientfelder ($G_y$ und $G_x$), wie unter Punkten b) und c) angegeben, um eine zweite Folge von Echosignalen zu erzeugen,

i) eine Vorrichtung zum Ermitteln der zweiten Folge von Echosignalen und zum Ableiten eines zweiten Bildsignals aus dieser Folge, und

j) eine Vorrichtung zum Verwenden des Unterschiedes zwischen dem ersten und dem zweiten Bildsignal, um ein Bildsignal abzuleiten, das auf den durch Vorrichtung e) ausgewählten Streifen begrenzt ist und ein Bild aus diesem Unterschied erzeugt hat, sowie eine Vorrichtung zum Erhöhen der Amplitude des phasenkodierenden Gradienten auf ein Niveau, das so bemessen ist, daß sich die Bilder von jeder Hälfte des Zwei-Bild-Aufnahmeverfahrens, wenn man sie separat betrachtet, in Phasenkodierungsrichtung überlagern, und daß das erhaltene Bild des ausgewählten Streifens in Richtung des phasenkodierenden Gradienten expandiert ist, um eine Flächenvergrößerung des Bildes des ausgewählten Streifens bereitzustellen.

## Revendications

1. Procédé d'agrandissement par zones d'une image obtenue par le procédé écho-planar, comportant au moins un procédé en deux temps comprenant les étapes suivantes consistant à:

a) appliquer une première impulsion sélective de radiofréquence ($\alpha °$) en présence d'un champ magnétique ($G_z$) à gradient de définition de tranche qui a'inverse pendant un court laps de temps après l'impulsion de radiofréquence, pour sélectionner une tranche d'un objet dont on veut obtenir une image,

b) appliquer de manière répétitive un champ magnétique ($G_y$) à gradient, à polarités successives alternées, et ayant un gradient orienté perpendiculairement au champ magnétique ($G_z$) à gradient de définition de tranche, afin de générer un premier train de signaux d'échos,

c) appliquer pendant l'étape b) un champ magnétique ($G_x$) à gradient de codage de phase, ayant un gradient orienté perpendiculairement audit champ magnétique répétitif ($G_y$) à gradient et parallèlement à la tranche choisie, de façon que les phases relatives des contributions aux signaux des divers éléments de l'échantillon diffèrent les unes des autres pour des signaux d'échos successifs,

d) détecter ledit premier train de signaux d'échos et élaborer à partir de celui-ci un premier signal d'image,

e) appliquer ensuite, en présence d'un champ magnétique ($G_x$) à gradient de sélection de bande une impulsion sélective de commande de radiofréquence à 180 ° pour inverser le magnétisme d'une bande à l'intérieur de la tranche choisie, la largeur de la bande dépendant de la valeur du gradient et des fréquences spectrales contenues dans l'impulsion de radiofréquence à 180 °,

f) appliquer en tant qu'impulsion d'extinction une impulsion ($G_z$) de champ magnétique à gradient,

g) appliquer une seconde impulsion sélective de radiofréquence ($\beta °$) en présence du champ magnétique ($G_z$) à gradient de définition de tranche pour sélectionner à nouveau la tranche de l'objet dont on veut obtenir une image,

h) répéter les étapes b) et c) pour générer un second train de signaux d'échos,

i) détecter ledit second train de signaux d'échos et élaborer à partir de celui-ci un second signal d'image,

j) prendre la différence entre les premier et second signaux d'image pour élaborer un signal d'image limité à la bande choisie lors de l'étape (e), l'amplitude du champ ($G_x$) à gradient de codage de phase appliqué lors de l'étape (c) étant telle que les images résultant de chaque moitié du procédé en deux temps, lorsqu'elles sont vues séparément, présentent un enveloppement dans la direction du codage de phase et que l'image ainsi obtenue de la bande choisie est dilatée dans la direction du gradient de codage de phase pour réaliser un agrandissement par zones de l'image de la bande choisie.

2. Procédé selon la revendication 1, dans lequel le champ magnétique (G-x) à gradient de codage est un champ à écho.

3. Procédé selon la revendication 2, dans lequel un écho dudit champ magnétique($G_x$) à gradient de codage de phase est produit au moment du changement de polarité dudit champ magnétique répétitif ($G_y$) à gradient générateur d'échos.

**4.** Procédé selon la revendication 1, dans lequel les angles de nutation des première et seconde impulsions sélectives de radiofréquence ($\alpha°$ et $\beta°$) sont liés par la relation tg $\alpha = \sin\beta$ .

**5.** Appareil pour l'agrandissement par zones d'une image obtenue par le procédé écho-planar au moins lors d'un procédé en deux temps, ledit appareil comportant un moyen programmé de manière appropriée pour commander des moyens a à j pour mettre en oeuvre le procédé selon la revendication 1, lesdits moyens a à j comprenant:

a) un moyen pour appliquer une première impulsion sélective de radiofréquence ($\alpha°$) en présence d'un champ magnétique ($G_z$) à gradient de définition de tranche, qui s'inverse pendant un court laps de temps après l'impulsion de radiofréquence, pour sélectionner une tranche d'un objet dont on veut obtenir une image,

b) un moyen pour appliquer de manière répétitive un champ magnétique ($G_y$) à gradient, à polarités successives alternées, et ayant un gradient orienté perpendiculairement au champ magnétique ($G_z$) à gradient de définition de tranche, afin de générer un premier train de signaux d'échos,

c) un moyen pour appliquer en même temps que l'application dudit champ magnétique répétitif ($G_y$) à gradient un champ magnétique ($G_x$) à gradient de codage de phase, ayant un gradient orienté perpendiculairement audit champ magnétique répétitif ($G_y$) à gradient et parallèlement à la tranche choisie, de façon que les phases relatives des contributions aux signaux des divers éléments de l'échantillon diffèrent les unes des autres pour des signaux d'échos successifs,

d) un moyen pour détecter ledit premier train de signaux d'échos et élaborer à partir de celui-ci un premier signal d'image,

e) un moyen pour appliquer ensuite, en présence d'un champ magnétique ($G_x$) à gradient de sélection de bande une impulsion sélective de commande de radiofréquence à 180° pour inverser le magnétisme d'une bande à l'intérieur de la tranche choisie, la largeur de la bande dépendant de la valeur du gradient et des fréquences spectrales contenues dans l'impulsion de radiofréquence à 180°,

f) un moyen pour appliquer en tant qu'impulsion d'extinction une impulsion ($G_z$) de champ magnétique à gradient,

g) un moyen pour appliquer une seconde impulsion sélective de radiofréquence ($\beta°$) en présence du champ magnétique ($G_z$) à gradient de définition de tranche pour sélectionner à nouveau la tranche de l'objet dont on veut obtenir une image,

h) un moyen pour ré-appliquer les champs magnétiques ($G_y$ et $G_x$) comme indiqué aux alinéas b) et c) pour générer un second train de signaux d'échos,

i) un moyen pour détecter ledit second train de signaux d'échos et élaborer à partir de celui-ci un second signal d'image,

j) un moyen pour prendre la différence entre les premier et second signaux d'image pour élaborer un signal d'image limité à la bande choisie à l'aide du moyen (e) et ayant établi une image à partir de la différence, et un moyen pour accroître l'amplitude du gradient de codage jusqu'à un niveau tel que les images résultant de chaque moitié du procédé en deux temps, lorsqu'elles sont vues séparément, présentent un enveloppement dans la direction du codage de phase et que l'image ainsi obtenue de la bande choisie est dilatée dans la direction du gradient de codage de phase pour réaliser un agrandissement par zones de l'image de la bande choisie.

Fig. 1

Signal time reversed

time

(a)

Composite

(b)

Fig. 2

*Fig. 3*

13

Fig. 4

Fig. 5

Fig. 6

Fig. 7

*Fig. 8*